# EUROPÄISCHE PATENTSCHRIFT

(11) **EP 3 008 440 B1**
(45) Veröffentlichungstag und Bekanntmachung des Hinweises auf die Patenterteilung: **29.11.2017**
(21) Anmeldenummer: 14724476.8
(22) Anmeldetag: 19.05.2014
(51) Int. Cl.: B23K 1/00, B23K 1/19, C23C 8/16, C23C 14/00, G01L 19/00, C23C 14/34, B23K 103/00, C23C 14/14, G01L 9/00

(54) **KAPAZITIVE, KERAMISCHE DRUCKMESSZELLE UND VERFAHREN ZU IHRER HERSTELLUNG**
CAPACITIVE, CERAMIC PRESSURE-MEASURING CELL AND METHOD FOR THE PRODUCTION THEREOF
CELLULE DE MESURE DE PRESSION CAPACITIVE EN CÉRAMIQUE ET PROCÉDÉ DE FABRICATION DE LADITE CELLULE DE MESURE DE PRESSION CAPACITIVE EN CÉRAMIQUE

(30) Priorität: 11.06.2013 DE 102013106045
(43) Veröffentlichungstag der Anmeldung: 20.04.2016
(73) Patentinhaber: Endress+Hauser GmbH+Co. KG, 79689 Maulburg (DE)
(72) Erfinder: PONATH, Nils, 79539 Lörrach (DE); ROßBERG, Andreas, 79713 Bad Säckingen (DE)
(74) Vertreter: Andres, Angelika Maria
(86) Internationale Anmeldenummer: PCT/EP2014/060186
(87) Internationale Veröffentlichungsnummer: WO 2014/198490

(56) Entgegenhaltungen:
- DE-B3-102008 036 381
- JP-A- 2002 214 059

## Beschreibung

Die vorliegende Erfindung betrifft eine kapazitive, keramische Druckmesszelle und ein Verfahren zu ihrer Herstellung.

Gattungsgemäße Druckmesszellen weisen eine keramische Messmembran und einen keramischen Gegenkörper auf, wobei die Messmembran mit dem Gegenkörper entlang einer umlaufenden Fügestelle, welche insbesondere ein Aktivhartlot aufweist, druckdicht verbunden ist, wobei zwischen der Messmembran und dem Gegenkörper eine Druckkammer gebildet ist, wobei sich die Gleichgewichtslage der Messmembran aus der Differenz zwischen einem in der Druckkammer herrschenden Druck und einem auf die der Druckkammer abgewandten Außenseite der Messmembran einwirkenden Druck ergibt. Gattungsgemäße Druckmesszellen umfassen weiterhin einen kapazitiven Wandler zum Wandeln der druckabhängigen Verformung der Messmembran in ein elektrisches Signal.

Die Offenlegungsschrift JP 2002 214 059 A offenbart einen kapazitiven Vakuumdrucksensor nicht mit einer keramischen Messmembran sondern mit einer Messmembran aus Silizium, die mit einer Schutzschicht aus Aluminiumoxid, Zirkoniumoxid oder Titanoxid gegen korrosive Gase zu schützen ist.

Als Material für den Gegenkörper und die Messmembran sind insbesondere Aluminiumoxidkeramiken im Einsatz, welche sich aufgrund ihrer elastischen Eigenschaften und ihrer Medienbeständigkeit zur Herstellung von Druckmesszellen eignen, Die genannten Keramikkomponenten werden insbesondere mit einem Aktivhartlot gefügt, welches bevorzugt ein Zr-Ni-Ti-haltiges Aktivhartlot ist. Die Herstellung eines solchen Aktivhartlots ist beispielsweise in der europäischen Offenlegungsschrift EP 0 490 807 A2 offenbart. Nach dem in der Offenlegungsschrift beschriebenen Verfahren lassen sich insbesondere Ringe aus dem Aktivhartiotmaterial herstellen, welche zwischen Messmembran und Gegenkörper zu positionieren sind, um diese miteinander zu verlöten.

DE 10 2008 036 381 B3 offenbart ein solcher Drucksensor mit einer hochfesten Messmembran, die eine Al₂O₃-Keramik aufweist, und mit einem Gegenkörper der eine Aluminiumoxidkeramik aufweist wobei die Messmembran und der Grundkörper mittels eines Aktivhartlots, beispielsweise mittels einer Zr-Ni-Ti-Legierung gefügt sind.

Als Elektrodenmaterial für Elektroden des kapazitiven Wandlers sind beispielsweise Niob, Tantal oder Siliziumkarbid bekannt, wobei die Oberfläche der Elektroden ggf. mit einer Glasschicht zu schützen ist, wie in der Veröffentlichung EP 0 544 934 A1 beschrieben ist. Gleichermaßen sind Elektroden bekannt, welche metallische Partikel in einer Glasmatrix umfassen und beispielsweise in der Offenlegungsschrift DE 10 2007 026 243 A1 beschrieben sind.

Die genannten Elektrodenmaterialien sind mit einem Hochtemperaturvakuumlötprozess zum Fügen von Aluminiumoxidkeramiken mittels eines Aktivhartlots kompatibel.

Der Temperaturbereich, in dem ein Aktivhartlot eine hochwertige, druckdichte Verbindung zu einem keramischen Werkstoff ausbildet, ist jedoch vergleichsweise schmal. Bei zu niedrigen Temperaturen ist das Lot einerseits nicht hinreichend reaktiv und andererseits ist es zu zäh, um sich gleichmäßig auf einem zu benetzenden Oberflächenbereich zu verteilen.

Bei zu hohen Temperaturen besteht dagegen die Gefahr, dass das Lot so niederviskos ist, dass es in Bereiche einläuft, die es nicht benetzen soll.

Bei der Fertigung von größeren Chargen von Messzellen, bleibt es allerdings nicht aus, dass in einem Ofen eine Temperaturverteilung gegeben ist, die den verfügbaren Temperaturbereich ausreizt. Um dennoch zu brauchbaren Ergebnissen zu gelangen, ist es bekannt, einen Lotstopp vorzusehen, welcher die Ausbreitung des Aktivlots begrenzt.

Eine praktizierte Methode zum Begrenzen des radial einwärts fließenden Aktivhartlots besteht darin eine Membranelektrode, welche Tantal aufweist, und welche mit dem Aktivhartlot in galvanischen Kontakt gelangen soll, oberflächlich zu oxidieren. Bei vergleichbar niedrigen Löttemperaturen kann damit ein Einlaufen des Aktivhartlots in die Druckkammer mit einer akzeptablen Ausbeute verhindert werden. Wenn jedoch die Löttemperatur erhöht wird, wirkt dieser Lotstopp nicht mehr zuverlässig, und das Lot fließt über den Rand der Tantalelektroden in die Druckkammer hinein. Abgesehen von dem schmalen Temperaturbereich, in dem die beschriebenen Druckmesszellen zu löten sind, besteht ein weiterer Nachteil darin, dass die Elektroden nun mindetens zwei Schichten mit unterschiedlichen Wärmeausdehnungskoeffizienten aufweisen, nämlich eine metallische Tantalschicht und eine Tantaloxidschicht. Dadurch können auf der Oberfläche der Messmembran temperaturabhängige mechanische Spannungen entstehen, die eine Temperaturhysterese bewirken.

Der vorliegenden Erfindung liegt daher die Aufgabe zugrunde, eine Druckmesszelle bereitzustellen, welche die genannten Probleme überwindet.

Die Aufgabe wird erfindungsgemäß gelöst, durch die Druckmesszelle gemäß dem Patentanspruch 1 und das Verfahren zur Herstellung einer Druckmesszelle gemäß dem unabhängigen Patentanspruch 11. Ein Ansatz dazu ergibt sich aus jüngeren Arbeiten zu einem verbesserten Lotstopp. Hierzu offenbart die noch unveröffentlichte deutsche Patentanmeldung DE 10 2013 105 132.4 eine Drurkmesszelle, welche eine keramische Messmembran und einen keramischen Gegenkörper aufweist, wobei die Messmembran mit dem Gegenkörper unter Bildung einer Druckkammer zwischen der Messmembran und dem Gegenkörper mittels eines Aktivhartlots druckdicht gefügt ist, wobei die Druckmesszelle weiterhin an einer Oberfläche der Messmembran und/oder des Gegenkörpers eine Lotstoppschicht aufweist, welche beim Fügen der Messmembran mit dem Gegenkörper verhindert, dass das Aktivhartlot über die Lotstoppschicht hinaus radial einwärts in die Druckkammer gelangt, wobei die Lotstoppschicht beispielsweise ein Titanoxid aufweist.

Diese Lotstoppschicht erweist sich als sehr wirksam und eröffnet damit einen weiteren Temperaturbereich zum Fügen der Druckmesszelle.

Ausgehend von diesem Befund verfolgt die vorliegende Erfindung nun den Ansatz, den Lotstopp und zumindest die Membranelektrode mit dem gleichen Werkstoffsystem, nämlich Titanoxid zu präparieren, welches ggf. dotiert sein kann, beispielsweise mit, Cr, Nb, W.

Die erfindungsgemäße Druckmesszelle weist eine keramische Messmembran und einen keramischen Gegenkörper auf, wobei die Messmembran mit dem Gegenkörper unter Bildung einer Druckkammer zwischen der Messmembran und dem Gegenkörper druckdicht gefügt ist, wobei die Messmembran eine der Druckkammer zugewandte Seite und eine der Druckkammer abgewandte Seite aufweist, wobei die Druckmesszelle weiterhin einen kapazitiven Wandler zum Erfassen einer druckabhängigen Verform ung der Messmembran aufweist, welcher mindestens eine an der Messmembran angeordnete Membranelektrode und mindestens eine gegenkörperseitige Elektrode aufweist, wobei die Membranelektrode an der der Druckkammer zugewandten Seite der Messmembran angeordnet ist, wobei erfindungsgemäß zumindest die eine Membranelektrode ein Titanoxid aufweist.

Das Titanoxid ist gemäß einer bevorzugten Weiterbildung der Erfindung ohne Zwischenschichten auf dem keramischen Material der Messmembran angeordnet.

Damit entfallen mögliche Quellen für störende mechanische Spannungen aufgrund von abweichenden Wärmeausdehnungskoeffizienten. Insofern als Titanoxid einen Wärmeausdehnungskoeffizienten aufweist der gut an den Wärmeausdehnungskoeffizienten von Korund angepasst ist, würde man durch weitere Schichten mit abweichenden Ausdehnungskoeffizienten, einen Teil der erzielten Vorteile wieder einbüßen.

Gemäß einer Weiterbildung der Erfindung weist die Membranelektrode Titanoxid auf, welches nichtstöchiometrisch ist, insbesondere Ti₄O₇, Ti₅O₉ oder Ti₆O₁₁.

Nicht stöchiometrisches Titanoxid weist eine höhere Leitfähigkeit auf als stöchiometrisches Titanoxid und ist insofern besonders gut als Elektrodenmaterial geeignet.

Gemäß einer Weiterbildung der Erfindung weist die Membranelektrode dotiertes Titanoxid auf, welches insbesondere mit Cr, Nb oder W dotiert ist.

Gemäß einer Weiterbildung beträgt die Dotierung bis zu etwa 10 Atom-% , insbesondere nicht mehr als 8 Atom-%, und bevorzugt nicht mehr als 6 Atom-% bezogen auf die Ti Atome.

Die Dotierung des Titanoxids führt zu einer noch weiter erhöhten Leitfähigkeit des Elektrodenmaterials.

Gemäß einer Weiterbildung der Erfindung ist die Messmembran mittels eines Aktivhartlots mit dem Grundkörper gefügt, wobei die Membranelektrode mit dem Aktivhartlot im galvanischen Kontakt steht.

Auf diese Weise kann die Membranelektrode zugleich als Lotstopp dienen, welcher ein Einlaufen des Aktivhartlots in die Druckkammer während des Lötens der Druckmesszelle verhindert. Durch die galvanische Kontaktierung der Elektrode mit dem Aktivhartlot, kann die Membranelektrode über die Fügestelle von der Mantelfläche der Druckmesszelle her kontaktiert werden, wobei sich durch eine leitfähige Beschichtung der Mantelfläche des Gegenkörpers, welche die Fügestelle kontaktiert, und ggf. einer leitfähigen Beschichtung einer der Messmembran abgewandten Rückseite des Gegenkörpers eine Schirmung der Gegenkörperseitigen Elektrode erzielen lässt, insbesondere in Form eines faradayschen Käfigs.

Der keramische Werkstoff der Messmembran und des Gegenkörpers umfassen gemäß einer Weiterbildung der Erfindung eine Aluminiumoxidkeramik, insbesondere eine hochreine Aluminiumoxidkeramik, wie sie beispielsweise in dem deutschen Patent DE 10 2008 036 381 B3 beschrieben ist. Die dort beschriebenen Reinheiten betreffen insbesondere die Keramik der Messmembran, für den Gegenkörper ist dagegen eine solche hochreine Keramik nicht zwingend erforderlich.

Gemäß einer Weiterbildung der Erfindung umfasst das Aktivhartlot ein Zirkon-Nickel-Titan-haltiges Aktivhartlot, wie es beispielsweise in der europäischen Patentanmeldung EP 0 490 807 A2 beschrieben ist.

Das erfindungsgemäße Verfahren zum Herstellen einer kapazitiven, Druckmesszelle umfasst:
Bereitstellen einer keramischen Messmembran und eines Gegenkörpers;

Präparieren mindestens einer membranseitigen Elektrode auf der Messmembran und mindestens einer gegenkörperseitigen Elektrode auf einer Oberfläche des Gegenkörpers;
druckdichtes Fügen der Messmembran mit dem Gegenkörper unter Bildung einer Druckkammer zwischen der Messmembran und dem Gegenkörper, wobei die Messmembran eine der Druckkammer zugewandte Seite und eine der Druckkammer abgewandte aufweist, wobei die membranseitige Elektrode an der der Druckkammer zugewandten Seite der Messmembran angeordnet ist,
wobei erfindungsgemäß zumindest die Membranelektrode Titanoxid umfasst.

Gemäß einer Weiterbildung wird zumindest die Membranelektrode präpariert, indem zunächst eine Metallschicht, also eine Titanschicht bzw. eine beispielsweise mit Cr, Nb, und/oder W dotierte Titanschicht gesputtert wird, die anschließend thermisch oxidiert wird.

In einer Weiterbildung der Erfindung erfolgt die Oxidation durch Erhitzen in einer sauerstoffhaltigen Atmosphäre, beispielsweise in Luft, wobei die Oxidation das Erhitzen auf eine Temperatur von nicht weniger als 500°C insbesondere nicht weniger als 600°C erfolgt.

In einer Weiterbildung der Erfindung wird zumindest die Membranelektrode durch reaktives Sputtern von Titanoxid präpariert, welches insbesondere dotiert sein kann, insbesondere mit Cr, Nb und/oder W.

Durch Präparation des Titanoxids mittels reaktiven Sputterns entfällt die anschließende Oxidation.

Gemäß einer Weiterbildung der Erfindung umfasst das Fügen der Messmembran mit dem Gegenkörper die folgenden Schritte:
Bereitstellen des Aktivhartlots zwischen der Messmembran und einem keramischen Gegenkörper in von dem Aktivhartlot zu benetzenden Oberflächenbereichen der Messmembran und des Gegenkörpers;
Erhitzen der Messmembran, des Gegenkörpers und des Aktivhartlots unter Vakuum bis zu einer Temperatur, bei der das Aktivhartlot schmilzt und mit der Messmembran und dem Gegenkörper reagiert; und
Abkühlenlassen der durch das Fügen gebildeten Druckmesszelle.

In einer Weiterbildung der Erfindung erfolgt das Fügen der keramischen Komponenten mit dem Aktivhartlot bei einer Temperatur von nicht weniger als 800 °C, insbesondere nicht weniger als 840 °C.

Die Erfindung wird nun anhand des in den Zeichnungen dargestellten Ausführungsbeispiels offenbart.

Es zeigt:
- Fig. 1:: einen Längsschnitt durch eine erfindungsgemäße Druckmesszelle;
- Fign. 2a - 2d:: eine Folge von Präparationsschritten zur Herstellung einer erfindungsgemäßen Druckmesszelle.

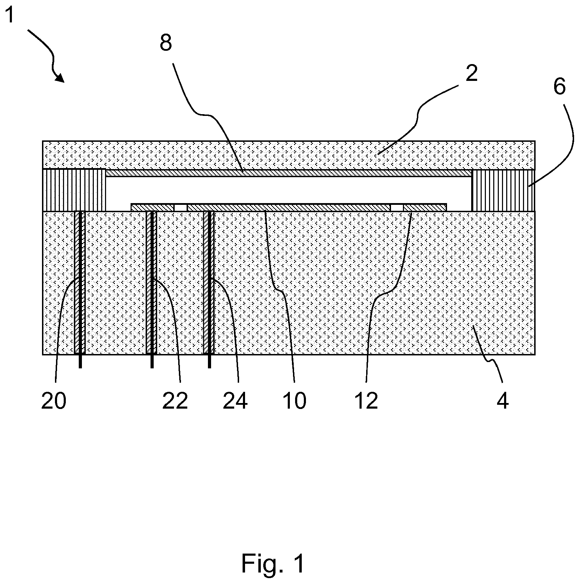

Die in Fig. 1 dargestellte Druckmesszelle 1 umfasst eine Messmembran 2, welche hochreines (>99,9%) Aluminiumoxid aufweist, und einen Gegenkörper 4, der ebenfalls Aluminiumoxid aufweist. Der Gegenkörper 4 kann die gleiche Reinheit wie die Messmembran aufweisen, wobei dies nicht zwingend erforderlich ist, da der Gegenkörper einerseits nicht medienberührend ist, so dass die Anforderungen an die Korrosionsbeständigkeit geringer sind und andererseits nicht den mechanischen Spannungen wie die Messmembran 2 ausgesetzt ist. Die Messmembran ist entlang einer umlaufenden Fügestelle 6, welche ein Zr-Ni-Ti-haltiges Aktivlot aufweist, unter Bildung einer Druckkammer zwischen der Messmembran 2 und dem Gegenkörper 4 druckdicht mit dem Gegenkörper verbunden.

Zum Erfassen einer druckabhängigen Verformung der Messmembran umfasst die Druckmesszelle 1 einen Differentialkondensator, der durch eine an der Messmembran 2 angeordnete Membranelektrode 8, eine zentrale gegenkörperseitige, kreisscheibenförmige Messelektrode 10 und eine, die Messelektrode umgebende Referenzelektrode 12 gebildet wird. Im Idealfall ist die Kapazitätzwischen der Messelektrode 10 und der Membranelektrode 8 gleich der Kapazität zwischen der Referenzelektrode 12 und der Membranelektrode 8, wenn sich die Messmembran 2 in der Ruhelage befindet. Die Membranelektrode 8 weist Titanoxid auf, welches unmittelbar auf dem keramischen Material der Messmembran 2 präpariert ist.

Das Titanoxid enthält vorzugsweise eine Dotierung mit einigen Atom-% Nb, wodurch die Leitfähigkeit des Elektrodenmaterials erheblich verbessert wird.

Die Referenzelektrode 12 und die Messelektrode 10 können einerseits ebenfalls Titanoxid aufweisen, welches ggf. dotiert ist, oder andererseits Platin bzw. Tantal. Sofern Tantalelektroden verwendet werden, sind diese vorzugsweise durch thermische Oxidation zu stabilisieren.

Die Membranelektrode 8 wird über die Fügestelle 6 und eine elektrische Durchführung 20, die sich im radialen Bereich der Fügestelle 6 durch den Gegenkörper erstreckt, elektrisch kontaktiert. Die Messelektrode 10 und die Referenzelektrode 12 sind direkt über elektrische Durchführungen 22, 24 durch den Gegenkörper 4 kontaktiert. Die elektrischen Durchführungen 20, 22, 24 umfassen beispielsweise Tantalstifte, welche mittels eines Aktivhartlots druckdicht in Bohrungen durch den Gegenkörper 4 eingelötet sind.

Die Membranelektrode 8, wirkt zugleich als Lotstopp, welches verhindert, das Aktivhartlot beim Verlöten von Gegenkörper 4 und Messmembran 2 daran gehindert wird, aus dem Randbereich radial einwärts in die Druckkammer zu fließen.

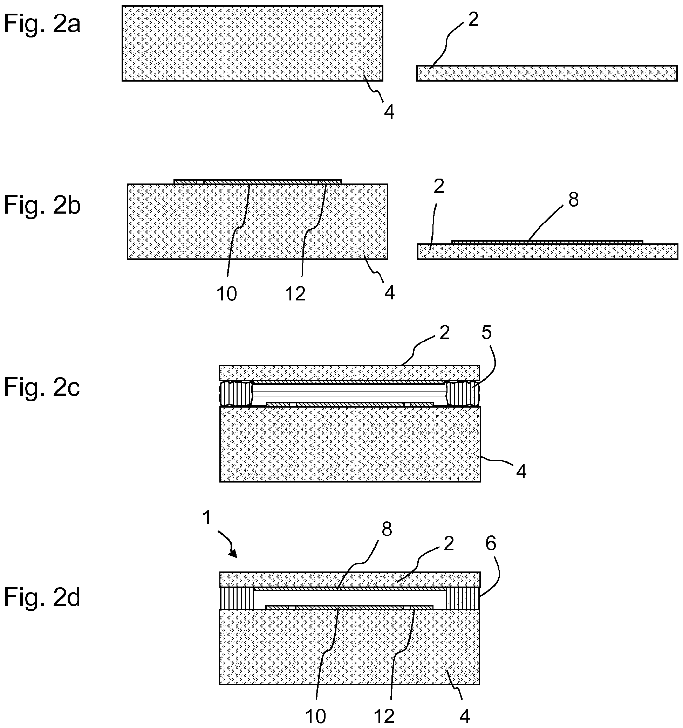

Anhand von Fign. 2a bis 2d werden nun kurz die Fertigungsschritte zum Herstellen der erfindungsgemäßen Druckmesszelle erläutert.

Zunächst werden, wie in Fig. 2 a dargestellt, eine kreisscheibenförmige Messmembran 2 aus hochreinem Korund und ein steiferer, kreisplattenförmiger Gegenkörper 4 aus Korund bereitgestellt.

Anschließend werden, wie in Fig. 2b dargestellt, auf dem Gegenkörper 4 und der Messmembran 2, die Flächen der Membranelektrode 8, der Messelektrode 10 und der Referenzelektrode 12 präpariert.

Die Membranelektrode 8 und ggf. weitere Elektroden auf Basis von Titanoxid umfasst bzw. umfassen hoch oxidiertes Titan, beispielsweise TiO₂ und/oder Ti₄O₇, welches durch Sputtern von Titan und ggf. Dotierungsmetallen (Cr, Nb, W) auf das keramische Material der Messmembran 2 bzw. des Gegenkörpers 4 und anschließende thermische Oxidation bei 600°C an Luft präpariert wird.

In einer alternativen Präparationsweise kann anstelle des metallischen Titans durch reaktives Sputtern kann unmittelbar Titanoxid abgeschieden werden, wodurch der anschließende Oxidationsschritt entfallen kann.

Zum Vorbereiten des Fügens der Messmembran 2 mit dem Gegenkörper 4 werden die beiden Fügepartner mit einem ringförmigen Lotformteil 5 dazwischen koaxial gestapelt, wie in Fig. 2c dargestellt ist. Das ringförmige Lotformteil 5 hat beispielsweise eine Höhe von etwa 30 µm bis 50 µm.

Abschließend werden die Komponenten in einem Hochvakuumlötprozess bei Temperaturen beispielsweise 950 °C gelötet, wobei das aufgeschmolzene Aktivhartlot mit den keramischen Oberflächen der Messmembran 2 und des Gegenkörpers 4 reagiert, allerdings kann es nicht über den Rand der Membranelektrode 8 in die Druckkammer einfließen, da der Sauerstoff aus dem Titanoxid zumindest teilweise in das Lot gelangt und damit das Lot verschlackt, so dass es erstarrt oder hochviskos wird und nicht weiter in die Druckkammer einfließt. Dennoch kommt es zu einem galvanischen Kontakt zwischen der Fügestelle 6 und der Membranelektrode 8, so dass über die Fügestelle eine metallische Beschichtung auf einer Mantelfläche der Druckmesszelle in Kontakt mit der Membranelektrode 8 gebracht werden kann.

Im Ergebnis führt dies zu der in Fig. 2d dargestellten Druckmesszelle.

Selbstverständlich umfasst auch diese die im Zusammenhang mit Fig. 1 beschriebenen elektrischen Durchführungen, die jedoch in Fign. 2a bis 2d im Sinne der Übersichtlichkeit weggelassen wurden. Die Durchführungen werden ebenfalls in dem Hochvakuumlötprozess eingelötet.

Insbesondere bei den Höhenverhältnissen wurde in den Zeichnungen auf Maßstabstreue verzichtet, um insbesondere die Schichten überhaupt darstellen zu können. Die radiale Größe der Druckmesszelle beträgt einige 10 mm. Die Höhe bzw. axiale Stärke des Gegenkörpers beträgt beispielsweise 3 bis 15 mm. Die Stärke der Messmembran beträgt beispielsweise nicht weniger 100 µm und beispielsweise nicht mehr als 2000 µm. Die Schichtdicke der Elektroden beträgt etwa 100 nm. Die Dimensionsangaben dienen lediglich zur Erläuterung und sind zur Definition oder einschränkenden Auslegung der Erfindung nicht heranzuziehen.

## Patentansprüche

1. Druckmesszelle (1), aufweisend:
eine keramische Messmembran (2); und
einen keramischen Gegenkörper (4),
wobei die Messmembran (2) mit dem Gegenkörper (4) unter Bildung einer Druckkammer zwischen der Messmembran und dem Gegenkörper druckdicht gefügt ist, wobei die Messmembran eine der Druckkammer zugewandte Seite und eine der Druckkammer abgewandte Seite aufweist,
wobei die Druckmesszelle (1) weiterhin einen kapazitiven Wandler zum Erfassen einer druckabhängigen Verformung der Messmembran (2) aufweist, welcher mindestens eine an der Messmembran angeordnete Membranelektrode (8) und mindestens eine gegenkörperseitige Elektrode (10, 12) aufweist,
wobei die Membranelektrode (8) an der der Druckkammer zugewandten Seite der Messmembran (2) angeordnet ist,
**dadurch gekennzeichnet,**
**dass** mindestens die eine Membranelektrode (2) ein Titanoxid aufweist.

2. Druckmesszelle (1) nach Anspruch 1, wobei das Titanoxid unmittelbar auf dem keramischen Material der Messmembran (2) angeordnet ist.

3. Druckmesszelle (1) nach Anspruch 1 oder 2, wobei die Membranelektrode (8) Titanoxid aufweist, welches nichtstöchiometrisch ist.

4. Druckmesszelle (1) nach Anspruch 3, wobei die Membranelektrode (8) nichtstöchiometrische Formen von TiO₂,Ti₄O₇, Ti₅O₉ oder Ti₆O₁₁ aufweist.

5. Druckmesszelle (1) nach einem der vorhergehenden Ansprüche, wobei die Membranelektrode (8) dotiertes Titanoxid aufweist.

6. Druckmesszelle (1) nach Anspruch 5,
wobei das Titanoxid mit Cr, Nb oder W dotiert ist.

7. Druckmesszelle (1) nach Anspruch 5 oder 6,
wobei die Dotierung bis zu etwa 8 Atom-% bezogen auf die Ti Atome beträgt.

8. Druckmesszelle (1) nach einem der vorhergehenden Ansprüche,
wobei die Messmembran (2) mittels eines Aktivhartlots (6) mit dem Grundkörper (4) gefügt ist,
wobei die Membranelektrode (8) mit dem Aktivhartlot (6) im galvanischen Kontakt steht.

9. Druckmesszelle (1) nach einem der vorhergehenden Ansprüche,
wobei die Messmembran (2) und der Gegenkörper (4) eine Aluminiumoxidkeramik aufweisen.

10. Druckmesszelle (1) nach einem der Ansprüche 8 oder 9,
wobei das Aktivhartlot (6) ein Zirkon-Nickel-Titan-haltiges Aktivhartlot umfasst.

11. Verfahren zum Herstellen einer kapazitiven Druckmesszelle nach einem der Ansprüche 1-10, wobei das Verfahren die folgenden Schritte aufweist:
• Bereitstellen der keramischen Messmembran (2) und des Gegenkörpers (4)
• Präparieren mindestens der membranseitigen Elektrode (8) auf der Messmembran (2) und mindestens der gegenkörperseitigen Elektrode (10, 12) auf einer Oberfläche des Gegenkörpers (4);
• druckdichtes Fügen der Messmembran mit dem Gegenkörper unter Bildung der Druckkammer zwischen der Messmembran (2) und dem Gegenkörper (4).

12. Verfahren nach Anspruch 11,
wobei die Membranelektrode (8) präpariert wird, indem die Titanschicht bzw. die dotierte Titanschicht gesputtert wird, die anschließend thermisch oxidiert wird.

13. Verfahren nach Anspruch 12,
wobei die Oxidation durch Erhitzen in einer sauerstoffhaltigen Atmosphäre auf eine Temperatur von nicht weniger als 600°C erfolgt.

14. Verfahren nach Anspruch 11,
wobei die Membranelektrode durch reaktives Sputtern von Titanoxid präpariert wird.

15. Verfahren nach Anspruch 14,
wobei das Titanoxid mit Cr, Nb, und/oder W dotiert ist.

## Claims

1. Pressure measuring cell (1), comprising:
a ceramic process isolating diaphragm (2); and
a ceramic counter-body (4);
wherein the process isolating diaphragm (2) is joined with the counter-body (4) in a pressure-tight manner, with the formation of a pressure chamber, wherein the process isolating diaphragm has a side facing towards the pressure chamber and a side facing away from the pressure chamber,
wherein the pressure measuring cell (1) further comprises a capacitance transducer for capturing a pressure-dependent deformation of the process isolating diaphragm (2), said transducer having at least one membrane electrode (8) arranged on the process isolating diaphragm and at least one electrode (10, 12) situated on the counter-body side,
wherein the membrane electrode (8) is arranged on the side of the process isolating diaphragm (2) facing towards the pressure chamber,
**characterized in that**
at least the one membrane electrode (8) features titanium oxide.

2. Pressure measuring cell (1) as claimed in Claim 1, wherein the titanium oxide is arranged directly on the ceramic material of the process isolating diaphragm (2).

3. Pressure measuring cell (1) as claimed in Claim 1 or 2, wherein the membrane electrode (8) features titanium oxide which is non-stoichiometric.

4. Pressure measuring cell (1) as claimed in Claim 3, wherein the membrane electrode (8) features non-stoichiometric forms of TiO₂, Ti₄O₇, Ti₅O₉ or Ti₆O₁₁.

5. Pressure measuring cell (1) as claimed in one of the previous claims, wherein the membrane electrode (8) features doped titanium oxide.

6. Pressure measuring cell (1) as claimed in Claim 5, wherein the titanium oxide is doped with Cr, Nb or W.

7. Pressure measuring cell (1) as claimed in Claim 5 or 6, wherein the doping is up to 8 atom-% in relation to the Ti atoms.

8. Pressure measuring cell (1) as claimed in one of the previous claims, wherein the process isolating diaphragm (2) is joined with the meter body (4) by means of an active brazing solder (6),
wherein the membrane electrode (8) is in galvanic contact with the active brazing solder (6).

9. Pressure measuring cell (1) as claimed in one of the previous claims, wherein the measuring membrane (2) and the counter-body (4) have an aluminum oxide ceramic.

10. Pressure measuring cell (1) as claimed in one of the Claims 8 or 9, wherein the active brazing solder (6) comprises an active brazing solder containing the components zirconium, nickel and titanium.

11. Procedure for producing a capacitance pressure measuring cell as claimed in one of the Claims 1 to 10, said procedure comprises the following steps:
- Provision of the ceramic process isolating diaphragm (2) and the counter-body (4);
- Preparation at least of the electrode on the membrane side (8) on the process isolating diaphragm (2) and at least of the electrode on the counter-body side (10, 12) on a surface of the counter-body (4);
- Pressure-tight joining of the process isolating diaphragm with the counter-body with the formation of the pressure chamber between the process isolating diaphragm (2) and the counter-body (4).

12. Procedure as claimed in Claim 11,
wherein the membrane electrode (8) is prepared by sputtering the titanium layer or the doped titanium layer which is then thermally oxidized.

13. Procedure as claimed in Claim 12,
wherein the oxidation is performed by heating in an atmosphere containing oxygen to a temperature of not less than 600 °C.

14. Procedure as claimed in Claim 11,
wherein the membrane electrode is prepared by the reactive sputtering of titanium oxide.

15. Procedure as claimed in Claim 14,
wherein the titanium oxide is doped with Cr, Nb and/or W.

## Revendications

1. Cellule de mesure de pression (1), présentant :
une membrane de mesure céramique (2) ; et
un contre-corps céramique (4) ;
cellule pour laquelle la membrane de mesure (2) est assemblée avec le contre-corps (4) de façon étanche à la pression, en formant une chambre de pression entre la membrane de mesure et le contre-corps, la membrane de mesure présentant un côté faisant face à la chambre de pression et un côté opposé à la chambre de pression,
la cellule de mesure de pression (1) présentant en outre un convertisseur capacitif destiné à la détection d'une déformation fonction de la pression de la membrane de mesure (2), lequel convertisseur comprend au moins une électrode de membrane (8) disposée sur la membrane de mesure et au moins une électrode (10, 12) située côté contre-corps,
l'électrode de membrane (8) étant disposée sur le côté de la membrane de mesure (2) située du côté de la chambre de pression,
**caractérisée**
**en ce que** l'au moins une électrode de membrane (8) présente un oxyde de titane.

2. Cellule de mesure de pression (1) selon la revendication 1, pour laquelle l'oxyde de titane est disposé directement sur le matériau céramique de le membrane de mesure (2).

3. Cellule de mesure de pression (1) selon la revendication 1 ou 2, pour laquelle l'électrode de membrane (8) comporte de l'oxyde de titane, qui n'est pas stoechiométrique.

4. Cellule de mesure de pression (1) selon la revendication 3, pour laquelle l'électrode de membrane (8) présente des formes non stoechiométriques de TiO₂, Ti₄O₇, Ti₅O₉ ou Ti₆O₁₁.

5. Cellule de mesure de pression (1) selon l'une des revendications précédentes, pour laquelle l'électrode de membrane (8) présente de l'oxyde de titane dopé.

6. Cellule de mesure de pression (1) selon la revendication 5, pour laquelle l'oxyde de titane est dopé avec du Cr, du Nb ou du W.

7. Cellule de mesure de pression (1) selon la revendication 5 ou 6, pour laquelle le dopage est de 8 % atomique rapporté aux atomes de Ti.

8. Cellule de mesure de pression (1) selon l'une des revendications précédentes, pour laquelle la membrane de mesure (2) est assemblée avec le corps de base (4) au moyen d'une brasure active (6),
l'électrode de membrane (8) étant en contact galvanique avec la brasure active (6).

9. Cellule de mesure de pression (1) selon l'une des revendications précédentes, pour laquelle la membrane de mesure (2) et le contre-corps (4) présentent une céramique d'oxyde d'aluminium.

10. Cellule de mesure de pression (1) selon la revendication 8 ou 9, pour laquelle la brasure active (6) contient du zirconium-nickel-titane.

11. Procédé destiné à la fabrication d'une cellule de mesure de pression capacitive selon l'une des revendications 1 à 10, le procédé comprenant les étapes suivantes :
- Mise à disposition de la membrane de mesure céramique (2) et du contre-corps (4) ;
- Préparation d'au moins une électrode côté membrane (8) sur la membrane de mesure (2) et d'au moins une électrode côté contre-corps (10, 12) sur une surface du contre-corps (4) ;
- Assemblage étanche à la pression de la membrane de mesure avec le contre-corps en formant une chambre de pression entre la membrane de mesure (2) et le contre-corps (4).

12. Procédé selon la revendication 11,
pour lequel l'électrode de membrane (8) est préparée en ce que la couche de titane ou la couche de titane dopée est pulvérisée, puis oxydée thermiquement.

13. Procédé selon la revendication 12,
pour lequel l'oxydation est effectuée par échauffement dans une atmosphère oxygénée à une température d'au moins 600 °C.

14. Procédé selon la revendication 11,
pour lequel l'électrode de membrane est préparée par pulvérisation réactive d'oxyde de titane.

15. Procédé selon la revendication 14,
pour lequel l'oxyde de titane est dopé avec du Cr, du Nb et/ou du W.
